Europäisches Patentamt

(19) European Patent Office

Office européen des brevets

(11) Publication number: **0 053 482**
**B1**

(12) **EUROPEAN PATENT SPECIFICATION**

(45) Date of publication of patent specification: **04.03.87**

(21) Application number: **81305590.2**

(22) Date of filing: **26.11.81**

(51) Int. Cl.⁴: **G 02 B 6/42**

(54) Module for a fiber optic link.

(30) Priority: **28.11.80 JP 166683/80**
**28.11.80 JP 166684/80**
**28.11.80 JP 166685/80**
**28.11.80 JP 166688/80**

(43) Date of publication of application:
**09.06.82 Bulletin 82/23**

(45) Publication of the grant of the patent:
**04.03.87 Bulletin 87/10**

(84) Designated Contracting States:
**DE FR GB**

(56) References cited:
**DE-A-3 004 379**
**US-A-4 136 357**
**US-A-4 173 389**
**US-A-4 186 995**

**IBM. TDB, Vol. 21, No. 4, September 1978, New York, pages 1568-70**

(73) Proprietor: **Kabushiki Kaisha Toshiba**
**72, Horikawa-cho Saiwai-ku**
**Kawasaki-shi Kanagawa-ken 210 (JP)**

(72) Inventor: **Donuma, Kenichi**
**2-4-19, Higashikoshigaya**
**Koshigaya-shi Saitama-ken (JP)**
Inventor: **Ohashi, Makoto**
**110 Miyazakidai-Greenheights 1-13-7, Miyazaki**
**Takatsu-ku Kawasaki-shi (JP)**
Inventor: **Ozeki, Takeshi**
**5-9-10-104, Kamiyoga Setagaya-ku**
**Tokyo (JP)**
Inventor: **Katagiri, Shuhei**
**2-12-1-706, Minami-Ooi Shinagawa-ku**
**Tokyo (JP)**
Inventor: **Sakura, Shigeyuki**
**Toshiba Shinkoyasu-ryo 2-14-10, Shinkoyasu**
**Kanagawa-ku Yokohama-shi (JP)**

(74) Representative: **Freed, Arthur Woolf et al**
**MARKS & CLERK 57-60 Lincoln's Inn Fields**
**London WC2A 3LS (GB)**

Courier Press, Leamington Spa, England.

**Description**

The present invention relates to a module for a fiber optic link and, more particularly, to a transmitter or receiver module for a fiber optic link.

In a fiber optic link, an optical signal generated in a transmitter module is guided to an optical fiber cable, is transmitted through the fiber cable, and is detected in a receiver module to be converted into an electric signal. In a fiber optic link of this type, optical coupling between the fiber cable and the receiver or transmitter modules, is important. In other words, it is required that an optical axis of an optoelectronic element in the module, that is, a photo-diode in the receiver module or a LED (Light Emitting Diode) in the transmitter module, be aligned with the optical axis at the end face of the optical fiber of the fiber cable in a precise manner, for example, within an error allowance of several to several tens of micrometers. In a conventional fiber optic link, an LED or photodiode as a single component is assembled in the transmitter module or in the receiver module. For this reason, the alignment of these electrical components and the optical fiber is not easy, and it is difficult to satisfactorily improve the light transmitting efficiency.

US—A—4 186 995 discloses a module for a fiber optic link which has a body case formed of a single body of moulded material and having an elongated plug hole for receiving a plug of a connector capable of being coupled with the body case by axial insertion of the plug in the plug hole; the body case also has a space in communication with the plug hole. The module also has a member fixed within the said space of the body case and has a lens. Leads extend from the said member outside the body case and an optoelectric element is connected to the leads and is received in the said member in a position axially aligned with the lens.

US—A—4 136 357 discloses a module for a fibre optic link having a body of transparent moulded material which encapsulates an integrated circuit chip. The body has a light input recess into which the end of a light pipe is inserted so as to be in register with a light sensitive area on the integrated circuit chip.

It is an object of the present invention to provide a module for a fiber optic link wherein an optical axis at the end face of an optical fiber may be aligned with an optical axis of an optoelectronic element in the module with high precision by simply mounting the optical fiber cable.

It is another object of the present invention to provide a module for a fiber optic link suitable for mass production.

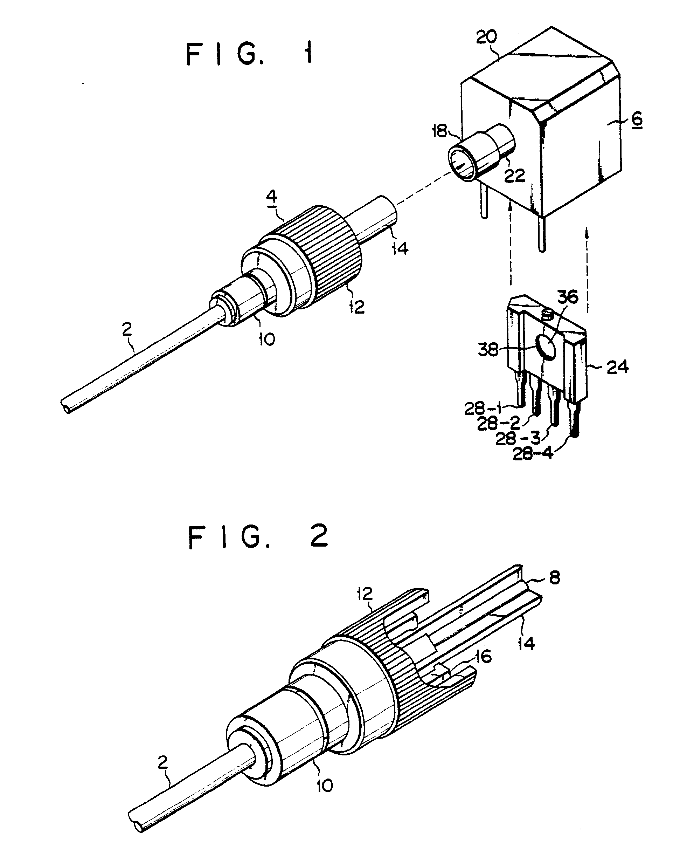

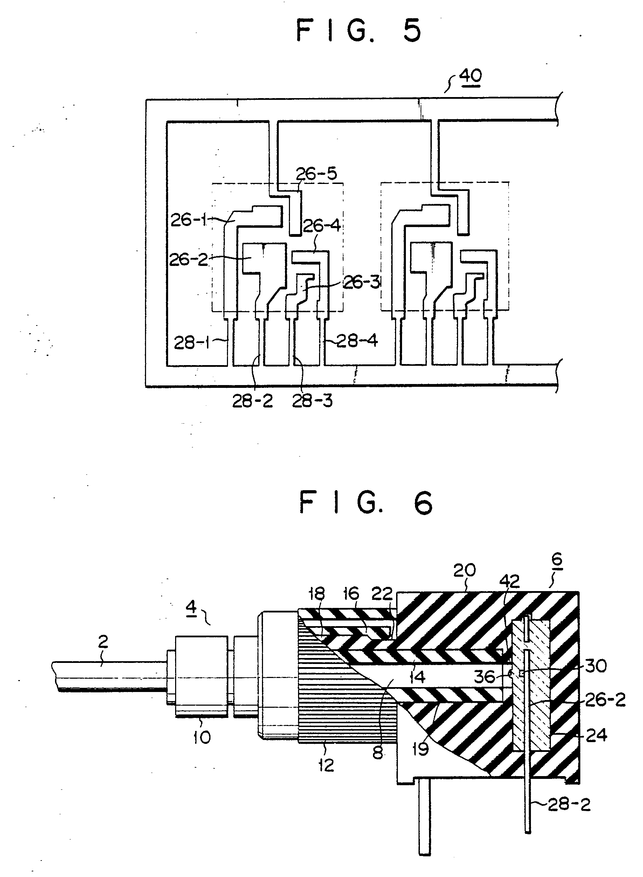

According to the present invention there is provided a module for a fiber optical link comprising a body case formed of a single body of a light-shielding molded material, said body case having an elongated plug hole for receiving a plug of a fiber optic connector capable of being coupled with the body case by axial insertion of the plug in the plug hole, and a space in communication with the plug hole; a member fixedly fitted in the space within the body case and having a convex lens facing the plug hole, with its optical axis aligned with the longitudinal axis of said plug hole; leads extending from the member outside of the body case; and an optoelectric element connected to one of the leads and received in the member in a position such that its optical axis is aligned with the optical axis of the convex lens and the longitudinal axis of the plug hole, characterized in that the member is formed of a single body of transparent molded material, in that the optoelectric element is mounted on that lead to which it is connected, in that the optoelectric element and the leads are embedded in the molded member, in that the convex lens is formed as an integral part of the molded member, at the region of said member where the optoelectric element is embedded, and in that, either the convex lens is formed in a recess of the member, in a manner such that the region of the member surrounding the recess presents a flat surface protruding beyond the lens so as to be contacted by the periphery of the flat plug end face upon insertion of the plug into the plug hole (Fig. 1, 3 and 7 to 11), or the convex lens is formed at the surface of said member and projects into the plug hole while the body case has a projection protruding radially inwardly into the plug hole and axially beyond the lens so as to be contacted by the periphery of the flat plug end face upon insertion of the plug into the plug hole (Fig. 6), whereby preventing direct contact between the lens and the plug end face.

This invention can be more fully understood from the following detailed description when taken in conjunction with the accompanying drawings, in which:

Fig. 1 is a perspective view showing a fiber optic link including a module according to an embodiment of the present invention;

Fig. 2 is a partially cut away perspective view showing the connector of Fig. 1;

Fig. 3 is a partially sectional view showing the module and the connector shown in Fig. 1 under the coupled condition;

Fig. 4 is a perspective view showing the internal structure of the circuit plate shown in Figs. 1 and 3;

Fig. 5 is a plan view showing a frame for manufacturing the circuit plate shown in Figs. 1 and 3;

Figs. 6 to 11 are sectional views showing modules according to other embodiments of the present invention; and

Fig. 12 is a sectional view showing dies for manufacturing the module shown in Fig. 10 and 11.

Fig. 1 shows the receiver side of a fiber optic link. The receiver side includes an optical fiber cable 2, a connector 4 fixed to one end of the fiber cable 2, and a module (receiver module) 6 to which is mounted the connector 4. Although not shown, the transmitter side of the fiber optic link is of substantially the same structure as that of the receiver side. The internal structure of the module is also the same for both the transmitter and receiver sides except for the circuit elements and optoelectronic element assembled in each module. Therefore, although the description will be made only with reference to the receiver module, it is to be understood that the module refers both to the receiver module and the transmitter module.

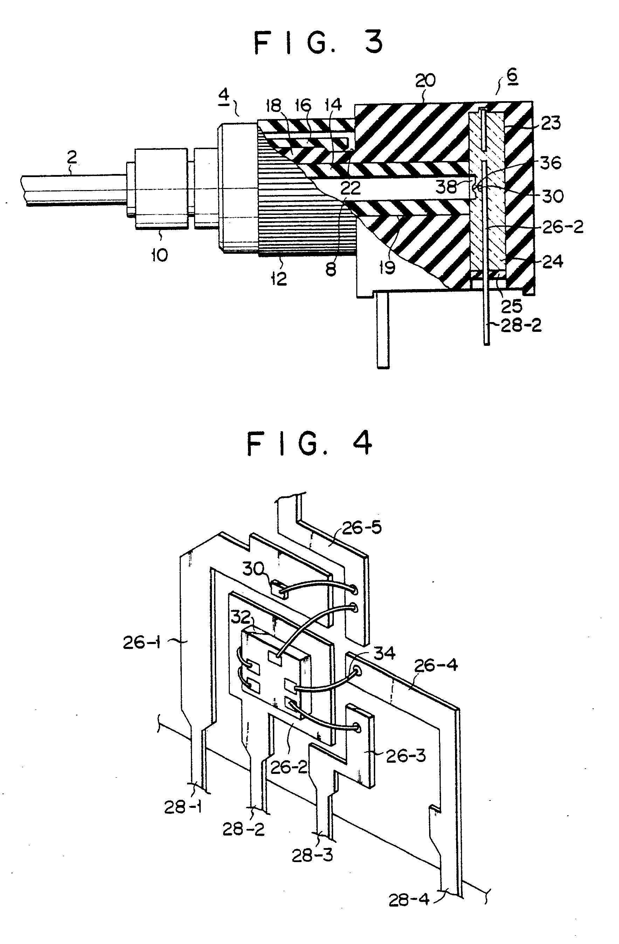

The optical fiber cable 2 is obtained in a generally known method by covering a plastic or glass optical fiber 8 comprising a core and a cladding with a flexible light-shielding material. The connector 4 is manufactured by injection molding. As shown in Fig. 2, the optical fiber cable 2 is fixed to a fixing section 10 of the connector 4. The optical fiber cable 2 further extends inside a cylindrical rigid plug 14 coaxially projecting from the fixing section 10 and terminates at the front end of the plug 14. A snap piece 16 is arranged inside a knurled section 12. A cylindrical socket 18 projects from a main body case 20 to correspond with the cylindrical rigid plug 14. The inner diameter of the socket 18 is set to be substantially equal to or slightly greater than the outer diameter of the plug 14. The outer diameter of the socket 18 is also set to be slightly greater than a distance between projections of the snap pieces 16 facing each other. As shown in Fig. 3, a stepped section 22 is formed at the socket 18 so as to engage with the snap piece of the connector 4 when the connector 4 is mounted to the socket 18. The hole 19 of the socket 18 in which is inserted the plug 14 communicates with a space 23 which extends inside the main body case 20 and in which circuit plate 24 is inserted. As will be described later, the module 6 is manufactured by injection molding as in the case of the connector 4. In contrast with this, the circuit plate 24 is manufactured by transfer molding. The receiver module 6 and the connector 4 are made of a light-shielding material which does not transmit light, while the circuit module plate 24 is made of a transparent resin. As shown in Fig. 4, within the circuit plate 24 are embedded five Ag-plated lead frames 26-1, 26-2, 26-3, 26-4 and 26-5. The lead frame 26-5 extends to and terminates at one side of the plate 24, while the other lead frames 26-1, 26-2, 26-3 and 26-4 extend to the outside the plate 24 at the other side and terminate into pins 28-1, 28-2, 28-3 and 28-4. On the lead frame 26-1 is mounted through a conductive paste an optoelectric element 30, a LED pellet in the case of the transmitter module and a photodiode in the case of the receiver module. On the lead frame 26-2 is mounted through a conductive paste a circuit element corresponding to the optoelectronic element 30, that is, an IC chip 32 in which a circuit, for example an amplifier, a comparator and related components or a driver circuit for the LED is formed. The bonding pads of the optoelectric element 30, the IC chip 32 and the lead frames 26-1, 26-2, 26-3, 26-4, and 26-5 are electrically connected through gold bonding wires 34. The optoelectronic element 30 is embedded at a predetermined position of the plate 24 so that the optoelectronic element 30 opposes the hole 19 of the socket 18 and is aligned with the central axis of the hole 19, when the circuit plate 24 is mounted within the main body case 20 of the module 6. A convex lens segment 36 for converging or diverging a light beam is formed at the region of the plate 24 where the optoelectronic element 30 is embedded, as shown in Fig. 3. This convex lens segment 36 is formed within a recess 38 on the plate 24 so as not to contact the optical fiber 8. When the circuit module plate 24 is housed within the main body case 20, the optical axis of the convex lens segment 36 and the optoelectronic element 30 is aligned with the central axis of the socket 18. The plate 24 is fixed to the main body case 20 with an adhesive 25, thus completing the module 6, that is, the receiver module or the transmitter module.

The method for manufacturing the module 6 as described above will now be described. Prior to the formation of the circuit plate 24, a copper plate is punched into a desired shape and is Ag-plated to provide a frame 40 as shown in Fig. 5. Next, the IC chip 32 and the optoelectronic element 30, that is, the LED or the photodiode, are mounted on the lead frames 26-1 and 26-2 with a conductive paste to be electrically connected thereto. The optoelectronic element 30 is connected to the lead frame 26-5 with a gold bonding wire having a diameter of 25 μm. The bonding pads of the IC chip 32 are respectively connected to the lead frames 26-2, 26-3, 26-4, and 26-5 with the bonding wires. The frame 40 with the IC chip 32 and the optoelectronic element 30 is mounted in a pair of dies (not shown) defining a cavity conforming to the outer shape of the circuit plate 24, as shown in Figs. 1 and 3. Into this cavity defined by these dies is transferred a transparent thermosetting resin, for example, a transparent thermosetting epoxy resin MP-8500 manufactured by Nitto Denshi-kogyo K. K., under certain conditions, for example, at a temperature of 160°C and a pressure of 30 kg/cm². After curing, the plate shown in Fig. 1 and Fig. 3 is completed.

As has been described above, the plate 24 obtained by transfer molding is prepared, and the case 20 of the module 6 for housing it is obtained by injection molding. Dies defining a recess conforming to the outer shape of the case 20 as shown in Fig. 1 and dies having an outer shape conforming to the outer shape of the hole of the socket 18 and the circuit module plate 24 are combined to define a cavity into which is injected a light-shielding thermosetting epoxy resin, for example, a black thermosetting epoxy resin EME-155F manufactured by Sumitomo Bakelite K. K., under certain conditions, for example, a temperature of 165°C and a pressure of 80 kg/cm². Thus the case 20 is completed after curing.

The plate 24 completed is inserted in the recess 23 of the case 20 for mounting the plate, as shown in Fig. 1. The plate 24 is fixed to the case 20 with an adhesive 25. The dies for molding the case 20 and the dies for molding the circuit plate 24 are manufactured in advance taking into consideration the expansion or shrinkage of the resin materials upon curing in the transfer molding process. Therefore, the plate 24 fits inside the case 20 relatively well. When the plate 24 is mounted to the case 20, the optical axis of the optoelectronic element 30 of the circuit module plate 24 is aligned with the central axis of the hole of the case 20.

The connector 4 is coupled to the module 6 obtained in this manner, as shown in Fig. 3. When the front end of the plug 14 inserted in the hole of the socket 18 shown in Figs. 1 and 3 contacts the surface of the circuit module plate 24, the projection of the snap piece 16 engages with the stepped section 22 of the socket 18, completing the mounting. During this process, since the central axis of the hole of the socket 18 is aligned with the optical axis of the optical fiber 8 inserted and fixed inside the plug 14, the optical axis of the optical fiber 8 is substantially aligned with the optical axis of the optoelectronic element 30. Furthermore, since the convex lens segment 36 is formed inside the recess 38 of the plate 24 and the front end of the plug 14 contacts the surface of the plate, the positioning of the plug is easy. The deformation of the optical fiber 8 due to contact with the convex lens segment 36 is prevented. Since the case 20 is manufactured by injection molding, the case 20 is resistant to abrasion and mechanical force. Since substantially no flashes are formed in the case 20 in injection molding, the case 20 may be molded with high precision. Since the circuit module plate 24 is manufactured by transfer molding, mass production is facilitated and smaller size may be attained. Therefore, the module 6 itself may be made compact in size.

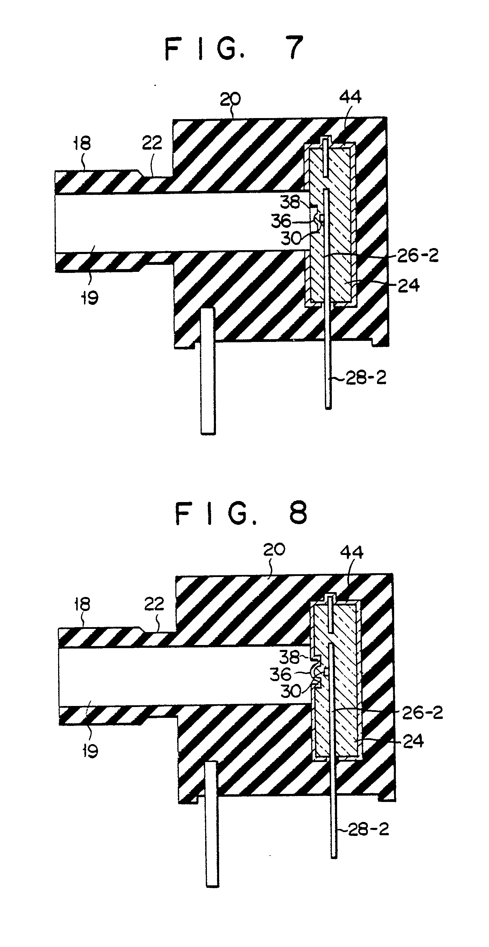

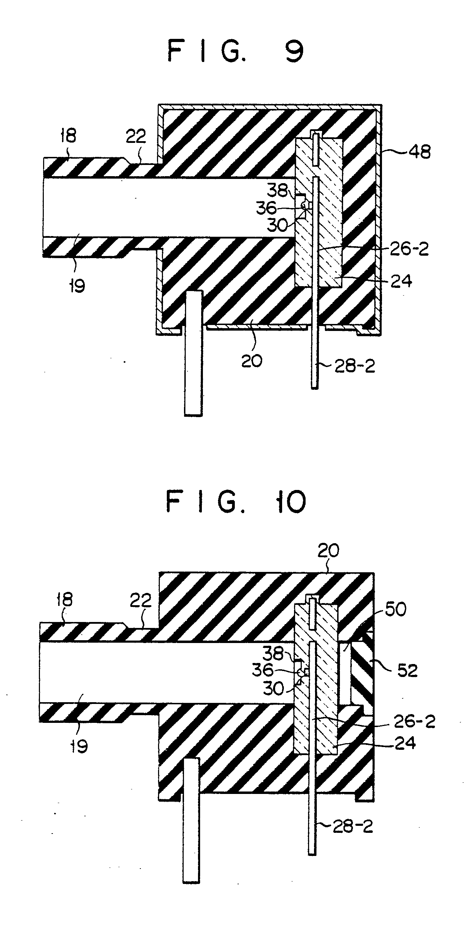

In the embodiment described above, the circuit module plate 24 and the case 20 are separately manufactured. However, the plate 24 may alternatively be mounted to the die in the injection molding of the case 20 to be integrally embedded inside the case 20, as shown in Fig. 6. Furthermore, as shown in Fig. 6, a recess may not be formed in the circuit module plate 24, and the convex lens segment 36 may be formed on the surface of the plate 24 and on the optical axis of the optoelectronic element 30 to project in the hole of the case 20. In this embodiment, a projection 42 is formed around the hole of the case 20 for positioning the front end of the plug 22. Obviously, dies for molding the case 20 with a cavity of a different shape from that of dies for molding the case 20 as shown in Fig. 3 may be easily manufactured. As shown in Figs. 7, 8 and 9, the module 6 may have a conductive film 44 for shielding out electromagnetic waves which might adversely affect the elements 30 and 32. This conductive film 44 may be connected to the lead frame 26-2 or the pin 28-2 which is grounded. If the conductive film 44 is not transparent, the plate 24 may be covered with the conductive film 44 except for the region opposing the hole of the socket of the case 20, as shown in Fig. 7. As shown in Fig. 8, the entire outer surface of the plate 24 is covered with the conductive film 44 if the conductive film 44 transmits light. If the plate 24 is not covered with the conductive film 44, the entire outer surface of the case 20 may be covered with a metal material 48 as shown in Fig. 9. Still alternatively, the case 20 itself may consist of a resin material mixed with a metal, and the pins 28-1 to 28-4 may be coated with an insulator. In the modules shown in Figs. 7, 8 and 9, since the optoelectronic elements 30 and the IC chips 32 are shielded from electromagnetic radiation, the introduction of noise in the signals generated by the modules may be prevented and the S/N ratio may be improved. This shielding from electromagnetic radiation is particularly preferably adopted for the receiver module. The signal obtained by photoelectric conversion at the photodiode is low in level and is amplified and shaped by the IC chip 32. If noise is introduced after such signal processing, the noise is also amplified and transmitted to a circuit of the next stage and this circuit thus receives erroneous information. The shielding from electromagnetic radiation is utilized to prevent this.

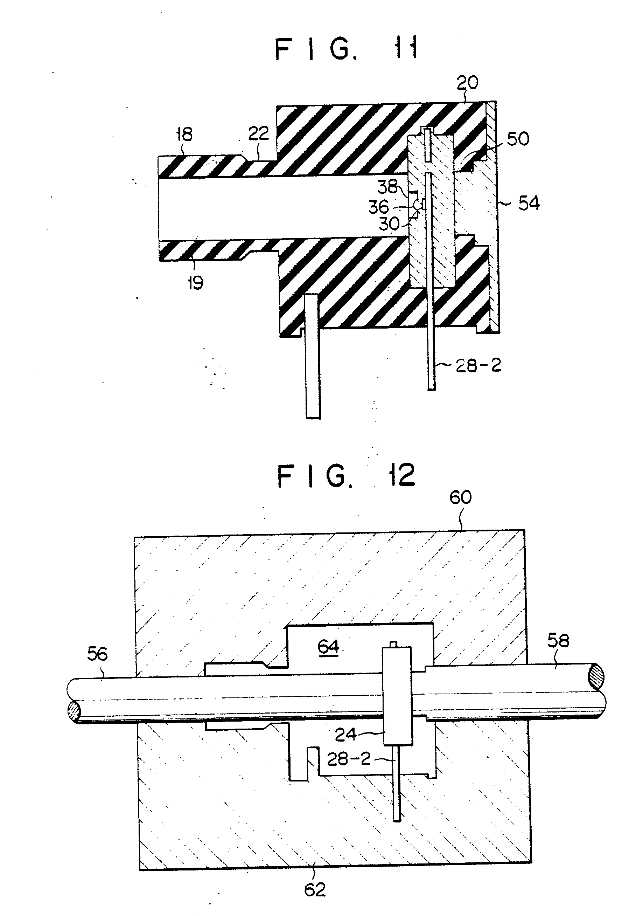

In order to manufacture the module 6 in large quantities and with good precision, the module 6 preferably has a structure as shown in Figs. 10 and 11. In the module 6 shown in Figs. 10 and 11, not only the hole 19 extends through the socket 18, but also a hole 50 which is coaxial with the central axis with the hole 19 is formed between the rear surface of the case 20 and the rear surface of the circuit plate 24. This hole 50 may be closed with a simple cap 52 for shielding a light from the outside as shown in Fig. 10. Alternatively, as shown in Fig. 11, the hole 50 may be closed with a heat radiation cap 54 which is adhered to the rear surface of the plate 24 for radiating the heat generated by the optoelectronic element 30 and the IC chip 32 in the plate 24.

The hole 50 as described above is formed because the module 6 is manufactured in the manner to be described below.

When the circuit plate 24 has been manufactured in the manner as described hereinabove, the plate 24 is (Fig. 12) clamped between the front ends of a pair of die rods 56 and 58 which have outer diameters equal to the inner diameters of the holes 19 and 50. By these die rods 56 and 58, the optical axis of the optoelectronic element 30 of the plate 24 is aligned with the central axis of the die rod 56. Then, dies 60 and 62 are attached as shown in Fig. 12, defining a cavity 64 of a shape conforming to the case 20. Thereafter, as has been described above, a resin is injected into the cavity 64 by injection molding and is cured. After curing, the die rods 56 and 58 are removed, and the dies 60 and 62 are withdrawn. The cap 52 or the radiation cap 54 is covered over the hole 50 formed in the case 20. According to this manufacturing method, the optical axis of the optoelectronic element 30 is aligned with the central axis of the die rod 56, and thereafter the molding takes place. Therefore, after the module 6 is manufactured, the optoelectronic element 30 is correctly aligned with the central axis of the hole 19 of the socket 18 and the case 20.

In summary, according to the module of the present invention, the optoelectronic element such as a LED or a photodiode and the peripheral circuits formed into an IC chip are embedded in a plate-shaped molded body. The case is manufactured in correspondence with this molded body. Therefore, correct alignment may be achieved by simply connecting the fiber optic cable to the module through the connector. Since this manufacturing method is suitable for mass production, the unit price of the module may be reduced.

**Claims**

1. A module (6) for a fiber optical link comprising a body case (20) formed of a single body of a light-shielding molded material, said body case having an elongated plug hole (19) for receiving a plug (14) of a fiber optic connector (4) capable of being coupled with the body case (20) by axial insertion of the plug (14) in the plug hole (19), and a space (23) in communication with the plug hole (19); a member (24) fixedly fitted in the space (23) within the body case (20) and having a convex lens (36) facing the plug hole, with its optical axis aligned with the longitudinal axis of said plug hole; leads (26-1, 26-2, 26-3, 26-4, 26-5, 28-1, 28-2, 28-3, 28-4) extending from the member (24) outside of the body case (20); and an optoelectric element (30) connected to one (26-1) of the leads and received in the member (24) in a position such that its optical axis is aligned with the optical axis of the convex lens (36) and the longitudinal axis of the plug hole, characterized in that the member (24) is formed of a single body of transparent molded material, in that the optoelectric element (30) is mounted on that lead (26-1) to which it is connected, in that the optoelectric element (30) and the leads (26-1, 26-2, 26-3, 26-4, 26-5, 28-1, 28-2, 28-3, 28-4) are embedded in the molded member (24), in that the convex lens (36) is formed as an integral part of the molded member, at the region of said member where the optoelectric element is embedded, and in that, either the convex lens is formed in a recess of the member, in a manner such that the region of the member surrounding the recess presents a flat surface protruding beyond the lens so as to be contacted by the periphery of the flat plug end face upon insertion of the plug into the plug hole (Fig. 1, 3 and 7 to 11), or the convex lens is formed at the surface of said member and projects into the plug hole while the body case has a projection protruding radially inwardly into the plug hole and axially beyond the lens so as to be contacted by the periphery of the flat plug end face upon insertion of the plug into the plug hole (Fig. 6), whereby preventing direct contact between the lens and the plug end face.

2. A module according to claim 1, characterized in that an IC chip (32) is mounted on one of said leads (26-1, 26-2, 26-3, 26-4, 26-5) in said member (24) and is electrically connected to said optoelectric element (30) and said leads (26-1, 26-2, 26-3, 26-4, 26-5).

3. A module according to claim 1 or 2, characterized in that said optoelectronic element (30) comprises an LED.

4. A module according to claim 1 or 2, characterized in that said optoelectronic element (30) comprises a photodiode.

5. A module according to claim 1, characterized in that said member (24) is embedded in said space (23) of said body case (20).

6. A module according to claim 1, characterized in that said member (24) is fixed with an adhesive (25) in the space (23) of said body case (20).

7. A module according to claim 1, characterized in that said body case (20) has an another hole (50) which is coaxial with said hole (19) and an outer opening of which is closed with a cap (52).

8. A module according to claim 1, characterized in that said member (24) is plate-shaped.

9. A module according to claim 1, characterized in that the surface of said member (24) except for said flat surface region and the recess (38) is covered with a material (44) for shielding out electromagnetic radiation.

10. A module according to claim 1, characterized in that said member (24) is covered on an entire outer surface thereof with a material (44) for shielding out electromagnetic radiation.

11. A module according to claim 1, characterized in that said body case (20) is covered with a material (48) for shielding out electromagnetic radiation.

12. A module according to claim 1, wherein said body case (20) is made of a molding material containing a material for shielding out electromagnetic radiation.

**Patentansprüche**

1. Modul (6) für einen fiberoptischen Anschluß, umfassend ein aus einem einzigen Körper aus einem lichtabschirmenden Formmaterial bestehendes Hauptgehäuse (20), das eine langgestreckte Steckerbohrung (19) zur Aufnahme eines Steckers (14) eines fiberoptischen Steckverbinders (4), der durch axiales Einführen des Steckers (14) in die Steckerbohrung (19) mit dem Hauptgehäuse (20) verbindbar ist, und einen mit der Steckerbohrung (19) in Verbindung stehenden Raum (23) aufweist, ein in den Raum (23) im Inneren des Hauptgehäuses (20) fest eingepaßtes Glied (24) mit einer der Steckerbohrung zugewandten konvexen Linse (36), deren optische Achse mit der Längsachse der Steckerbohrung fluchtet, vom Glied (24) zur Außenseite des Hauptgehäuses (20) abgehende Zuleitungen (26-1, 26-2, 26-3, 26-4, 26-5, 28-1, 28-2, 28-3, 28-4) und ein optoelektrisches Element (30), das mit einer (26-1) der Zuleitungen verbunden und in das Glied (24) in einer solchen Lage eingesetzt ist, daß seine optische Achse mit der optischen Achse der konvexen Linse (36) und der Längsachse der Steckerbohrung fluchtet, dadurch gekennzeichnet, daß das Glied (24) aus einem einzigen Körper aus einem (einer) durchsichtigen Formmaterial (oder -masse) gebildet ist, daß das optoelektrische Element (30) an der Zuleitung (26-1), mit welcher es verbunden ist, montiert ist, daß das optoelektrische Element (30) und die Zuleitungen (26-1, 26-2, 26-3, 26-4, 26-5, 28-1, 28-2, 28-3, 28-4) in das geformte Glied (24) eingebettet sind, daß die konvexe Linse (36) als einheitlicher Teil des geformten Glieds in dem Bereich desselben, in welchem das optoelektrische Element eingebettet ist, ausgebildet ist und daß entweder die konvexe Linse in einer Ausnehmung des Glieds in der Weise ausgebildet ist, daß der die Ausnehmung umgebende Bereich des Glieds eine über die Linse hinaus vorstehende ebene Fläche bildet, die beim Einführen des Steckers in die Steckerbohrung mit dem Umfang der flachen Stecker-Stirnfläche in Berührung gelangt (Fig. 1, 3 und 7 bis 11), oder die konvexe Linse an der Oberfläche des Glieds ausgebildet ist und in die Steckerbohrung hineinragt, während das Hauptgehäuse einen radial einwärts in die Steckerbohrung hinein vorstehenden und axial über die Linse hinaus ragenden Ansatz (oder Flansch) aufweist, der beim Einführen des Steckers in die Steckerbohrung mit dem Umfang der flachen Stecker-Stirnfläche in Berührung gelangt (Fig. 6), so daß eine unmittelbare Berührung zwischen Linse und Stecker-Stirnfläche verhindert ist.

2. Modul nach Anspruch 1, dadurch gekennzeichnet, daß an einer der Zuleitungen (26-1, 26-2, 26-3, 26-4, 26-5) im Glied (24) ein integrierter Schaltkreisoder IC-Chip (32) angebracht und elektrisch mit dem optoelektrischen Element (30) und den Zuleitungen (26-1, 26-2, 26-3, 26-4, 26-5) verbunden ist.

3. Modul nach Anspruch 1 oder 2, dadurch gekennzeichnet, daß das optoelektronische Element (30) eine Leuchtdiode ist.

4. Modul nach Anspruch 1 oder 2, dadurch gekennzeichnet, daß das optoelektronische Element (30) eine Photodiode ist.

5. Modul nach Anspruch 1, dadurch gekennzeichnet, daß das Glied (24) in den Raum (23) des Hauptgehäuses (20) eingebettet ist.

6. Modul nach Anspruch 1, dadurch gekennzeichnet, daß das Glied (24) mit Hilfe eines Klebmittels (25) im Raum (23) des Hauptgehäuses (20) befestigt ist.

7. Modul nach Anspruch 1, dadurch gekennzeichnet, daß das Hauptgehäuse (20) eine weitere, zur Bohrung (19) koaxiale Bohrung (50) aufweist, deren außenseitige Öffnung mittels einer Kappe (52) verschlossen ist.

8. Modul nach Anspruch 1, dadurch gekennzeichnet, daß das Glied (24) plattenförmig ausgebildet ist.

9. Modul nach Anspruch 1, dadurch gekennzeichnet, daß die Oberfläche des Glieds (24), mit Ausnahme des ebenen Flächenbereichs und der Ausnehmung (38), mit einem Material (44) zum Abschirmen elektromagnetischer Strahlung überzogen ist.

10. Modul nach Anspruch 1, dadurch gekennzeichnet, daß das Glied (24) an seiner gesamten Außenfläche mit einem Material (44) zum Abschirmen elektromagnetischer Strahlung überzogen ist.

11. Modul nach Anspruch 1, dadurch gekennzeichnet, daß das Hauptgehäuse (20) mit einem Material (48) zum Abschirmen elektromagnetischer Strahlung überzogen ist.

12. Modul nach Anspruch 1, dadurch gekennzeichnet, daß das Hauptgehäuse (20) aus einem Formmaterial, das ein Material zum Abschirmen elektromagnetischer Strahlung enthält, hergestellt ist.

**Revendications**

1. Module (6) destiné à une liaison à optique à fibre comprenant un boîtier (20) formé d'un corps unique d'un matériau moulé opaque, le boîtier ayant un trou allongé (19) de logement d'un bouchon (14) d'un connecteur (4) à optique à fibre capable d'être accouplé au boîtier (20) par introduction axiale du bouchon (14) dans le trou (19) prévu à cet effet, et un espace (23) communiquant avec le trou (19) du bouchon, un organe (24) monté de manière fixe dans cet espace (23) formé dans le boîtier (20) et ayant une lentille convexe (36) tournée vers le trou du bouchon, son axe optique étant aligné sur l'axe longitudinal du trou du bouchon, des fils de connexion (26-1, 26-2, 26-3, 26-4, 26-5, 28-1, 28-2, 28-3, 28-4) dépassant dudit organe (24) vers l'extérieur du boîtier (20) et un élément optoélectrique (30) raccordé à l'un des fils de connexion (26-1) et logé dans ledit organe (24) en position telle que son axe optique est aligné sur l'axe optique de la lentille convexe (36) et sur l'axe longitudinal du trou du bouchon, caractérisé en ce que ledit organe (24) est formé d'un corps unique d'un matériau transparent moulé, en ce que l'élément optoélectrique (30) est monté sur le fil de connexion (26-1) auquel il est connecté, en ce que l'élément optoélectrique (30) et les fils de connexion (26-1, 26-2, 26-3, 26-4, 26-5, 28-1, 28-2, 28-3, 28-4) sont enrobés dans l'organe moulé (24), en ce que la lentille convexe (36) est formée d'un élément solidaire de l'organe moulé, dans la région dudit organe dans laquelle l'élément optoélectrique est enrobé, et en ce que soit la lentille convexe est formée dans une cavité dudit organe de manière que la région de l'organe entourant la cavité présente une surface plate dépassant au-delà de la lentille afin qu'elle soit un contact de la périphérie de la face plate d'extrémité du bouchon après introduction du bouchon dans le trou du bouchon (figures 1, 3 et 7 à 11), soit la lentille convexe est formée à la surface dudit organe et dépasse dans le trou du bouchon alors que le boîtier a une saillie dépassant radialement vers l'intérieur dans le trou du bouchon et axialement au-delà de la lentille afin qu'elle soit au contact de la périphérie de la face plate d'extrémité du bouchon après introduction du bouchon dans le trou du bouchon (figure 6), si bien qu'un contact direct entre la lentille et la face d'extrémité du bouchon est empêché.

2. Module selon la revendication 1, caractérisé en ce qu'une pastille de circuit intégré (32) est montée sur l'un des fils de connexion (26-1, 26-2, 26-3, 26-4, 26-5) dans ledit organe (24) et est connectée électriquement à l'élément optoélectrique (30) et aux fils de connexion (26-1, 26-2, 26-3, 26-4, 26-5).

3. Module selon l'une des revendications 1 et 2, caractérisé en ce que l'élément optoélectronique (30) est une diode photoémissive.

4. Module selon l'une des revendications 1 et 2, caractérisé en ce que l'élément optoélectronique (30) est une photodiode.

5. Module selon la revendication 1, caractérisé en ce que ledit organe (24) est enrobé dans ledit espace (23) du boîtier (20).

6. Module selon la revendication 1, caractérisé en ce que ledit organe (24) est fixé par un adhésif (25) dans ledit espace (23) du boîtier (20).

7. Module selon la revendication 1, caractérisé en ce que le boîtier (20) a un autre trou (50) qui est coaxial au trou du bouchon (19) et ayant une ouverture externe qui est fermée par un capuchon (52).

8. Module selon la revendication 1, caractérisé en ce que ledit organe (24) a la forme d'une plaque.

9. Module selon la revendication 1, caractérisé en ce que la surface dudit organe (24) mis à part la région superficielle plate et la cavité (38), est recouverte d'une matière (44) assurant une protection contre le rayonnement électromagnétique.

10. Module selon la revendication 1, caractérisé en ce que ledit organe (24) est recouvert sur toute sa surface externe par une matière (44) de protection contre le rayonnement électromagnétique.

11. Module selon la revendication 1, caractérisé en ce que le boîtier (20) est recouvert d'une matière (48) de protection contre le rayonnement électromagnétique.

12. Module selon la revendication 1, dans lequel le boîtier (20) est formé d'un matériau de moulage contenant une matière de protection contre le rayonnement électromagnétique.

F I G.   1

F I G.   2

# F I G. 3

# F I G. 4

# F I G. 5

# F I G. 6

# F I G. 7

# F I G. 8

# F I G. 9

# F I G. 10

# F I G. 11

# F I G. 12